## Europäisches Patentamt
## European Patent Office
## Office européen des brevets

(19)

(11) Veröffentlichungsnummer: **0 140 837**
**B1**

(12) **EUROPÄISCHE PATENTSCHRIFT**

(45) Veröffentlichungstag der Patentschrift:
**30.03.88**

(51) Int. Cl.⁴: **B 23 P 21/00, H 05 K 13/02**

(21) Anmeldenummer: **84810504.5**

(22) Anmeldetag: **15.10.84**

(54) **Bestückungs- und Montageautomat.**

(30) Priorität: **21.10.83 CH 5739/83**

(43) Veröffentlichungstag der Anmeldung:
**08.05.85 Patentblatt 85/19**

(45) Bekanntmachung des Hinweises auf die Patenterteilung:
**30.03.88 Patentblatt 88/13**

(84) Benannte Vertragsstaaten:
**DE FR GB IT**

(56) Entgegenhaltungen:
**EP - A - 0 076 231**
**DD - A - 201 270**
**DE - A - 3 127 047**
**DE - A - 3 231 174**
**US - A - 4 312 107**
**US - A - 4 380 868**
**US - A - 4 383 359**

(73) Patentinhaber: **Kaiser, Lothar, Höhenweg 4,
CH-5734 Reinach (CH)**

(72) Erfinder: **Kaiser, Lothar, Höhenweg 4, CH-5734 Reinach
(CH)**

(74) Vertreter: **Haffter, Tobias Fred, Dr. Dipl.-Phys. et al,
PATENTANWALTS-BUREAU ISLER AG
Postfach 6940 Walchestrasse 23, CH-8023 Zürich (CH)**

## Beschreibung

Die vorliegende Erfindung bezieht sich auf einen Bestückungs- und Montageautomaten zur Bestückung von Bauteilen für Maschinen, Geräte oder elektrische Anordnungen mit einzelnen Bau- oder Schaltungselementen.

Bei der maschinellen Bestückung von Bauteilen für Maschinen, Geräte oder elektrische Anordnungen ist es bekannt, für eine zeitsparende Arbeitsweise das Bauteil zu einem Montageplatz zu verbringen und verschiedene Bau- oder Schaltungselemente mit geeigneten Greiferwerkzeugen in die vorgesehene Lage zu bringen. Die Verwendung eines solchen Werkzeuges zusammen mit einer automatischen Elementezuführung ergibt eine kurze Taktzeit und kurze Wege beim Ablegen der Elemente.

Maschinen mit solchen Werkzeugen eignen sich jedoch nur bei etwa 70% der beispielsweise in der Elektronik verwendeten Bauelemente, nämlich Widerstände, Kondensatoren, Dioden, Transistoren und integrierte Schaltungen. Weitere Bauelemente, wie Transformatoren, Stiftleisten, Druckleisten, Relais usw. können mit derartigen Bestückungsmaschinen nicht verarbeitet werden und müssen von Hand eingesetzt werden. Es ist verständlich, dass diese Handarbeit, um solche als Exoten bezeichnete Bauelemente einzusetzen, die Montagekosten stark erhöht.

Andererseits sind Montageautomaten für Maschinenbauteile bekannt, bei welchen auf einem Drehtisch Halter für das Bauteil angeordnet sind. In mehreren Positionen des Drehtisches wird jeweils eines der Bauelemente montiert. Dazu sind Handhabungsvorrichtungen bekannt, um die Montage zu automatisieren. Solche Automaten sind im allgemeinen zur Montage eines ganz bestimmten Bauteils gebaut und können nur unter grossem Aufwand auf die Montage eines andern Bauteils umgerüstet werden.

Es ist zwar möglich, als Handhabungsvorrichtungen programmierbare Roboter einzusetzen (US-A 4 383 359 und EP-A 76 231), was dem Automaten eine gewisse Flexibilität verleiht, doch sind solche Roboter, da sie nur einen Greifarm haben, auch mit speziellen Ausrüstungen wie Revolvergreifer oder Wechselgreifer für die Produktion grösserer Serien zu langsam.

Bei der Vorrichtung gemäss US-A 4 383 359, gegenüber welcher der Anspruch 1 abgegrenzt ist, wird das zu bestückende Bauteil durch ein Förderband einer ortsfesten Stelle zugeführt. Ein Roboter greift jeweils eines von mehreren unterschiedlichen, je aus einem Speicher einer zugehörigen Entnahmestelle zugeführten Bauelementen und setzt es an der ihm zugeordneten Stelle ins Bauteil ein. Dazu benötigt der Roboter viele Freiheitsgrade. Er ist deshalb relativ schwer und seine Bewegungen entsprechend langsam, insbesondere weil auch die von seinem Greifarm zurückgelegten Wegstrecken lang sind. Ausserdem ist er recht aufwendig zu programmieren.

Aus der DE-A 3 127 047 ist ferner eine Vorrichtung zum Einlegen eines Federrings in die Nut einer ringförmigen Lippendichtung bekannt. Federring und Lippendichtung werden durch je ein Drehkreuz erfasst und wiederum an einer ortsfesten Stelle zusammenmontiert. Diese Vorrichtung eignet sich ausschliesslich zur Bestückung von Lippendichtungen und kann nicht für die Bestückung unterschiedlicher Bauteile mit einer Mehrzahl unterschiedlicher Bauelemente angepasst werden.

Aus der US-A 4 312 107 ist ferner eine Vorrichtung zum Aufnieten eines Bremsbelages auf eine Bremsbacke bekannt. Die Bremsbacke wird auf eine drehbare Welle montiert. Durch Indexieren der Welle wird die Bremsbacke schrittweise unter zwei Nietvorrichtungen durchgeführt, bei welchen aus einem Speicher Nieten durch eine Handhabungsvorrichtung je einer ortsfesten Stelle zugeführt werden. Diese Vorrichtung ist ausschliesslich zum Bestücken von Bremsbacken mit Bremsbelägen geeignet.

Eine weitere Montagevorrichtung ist in der US-A 4 380 868 beschrieben. Hier werden Wärmetauscherrohre in gelochte Platten montiert. Die Platten werden zunächst auf einen in vertikaler Richtung verschiebbaren Schlitten befestigt. Auf einem zweiten, horizontal verschiebbaren Schlitten ist ein Speicher für die zu montierenden Rohre und ein Einschubzylinder befestigt. Entsprechend der Lage der zu bestückenden Bohrung der Platten werden die Schlitten positioniert und das entsprechende Rohr eingeschoben. Es handelt sich dabei ebenfalls um eine Einzweckmaschine, bei welcher es nicht möglich ist, ein Bauteil mit mehreren unterschiedlichen Bauelementen zu bestücken.

Die Aufgabe der Erfindung besteht darin, einen Bestückungs- und Montageautomaten derart auszubilden, dass ein Bauteil mit kurzen Taktzeiten mit unterschiedlichen Bau- oder Schaltungselementen rationell bestückt werden kann, und dass der Automat einfach auf die Bestückung anderer Bauteile mit anderen Bau- oder Schaltungselementen umstellbar ist. Diese Aufgabe wird durch die Merkmalskombination gemäss Anspruch 1 gelöst.

Dadurch, dass der Halter verschiebbar ist, können die Handhabungsvorrichtungen die Bau- oder Schaltungselemente einer für alle Handhabungsvorrichtungen gemeinsame ortsfeste Stelle, zuführen. Es ergeben sich dadurch kurze Transportwege der Bau- oder Schaltungselemente und einfache, rasch bewegbare Handhabungsvorrichtungen. Während des Rückhubes dieser Vorrichtungen kann das Bauteil mittels der Schlittenanordnung bereits in seine neue Lage gebracht werden, so dass die kurzen Transportwege und hohen Transportgeschwindigkeiten der Bau- und Schaltungselemente kurze Taktzeiten ermöglichen. Die Änderung auf die Bestückung eines andern Bauteils oder auf einen andern Bestückungsplan des Bauteils ist ohne weiteres durch Umprogrammieren der Verschiebevorrichtung für den Halter möglich. Es lassen sich Bau- und Schaltungselemente unterschiedlichster Grösse montieren.

Ausführungsbeispiele erfindungsgemässer Bestückungs- und Montageautomaten werden nachstehend anhand der Zeichnungen erläutert. Es zeigen:

Fig. 1 den Aufriss eines Bestückungsautomaten für Leiterplatten,

Fig. 2 den Grundriss des Automaten der Fig. 1,

Fig. 3 den Grundriss eines Montageautomaten für Schliesszylinder,

Fig. 4 den Schnitt längs der Linie IV-IV in Fig. 3,

Fig. 5 eine in einen Schliesszylinder einsetzbare Lamelle.

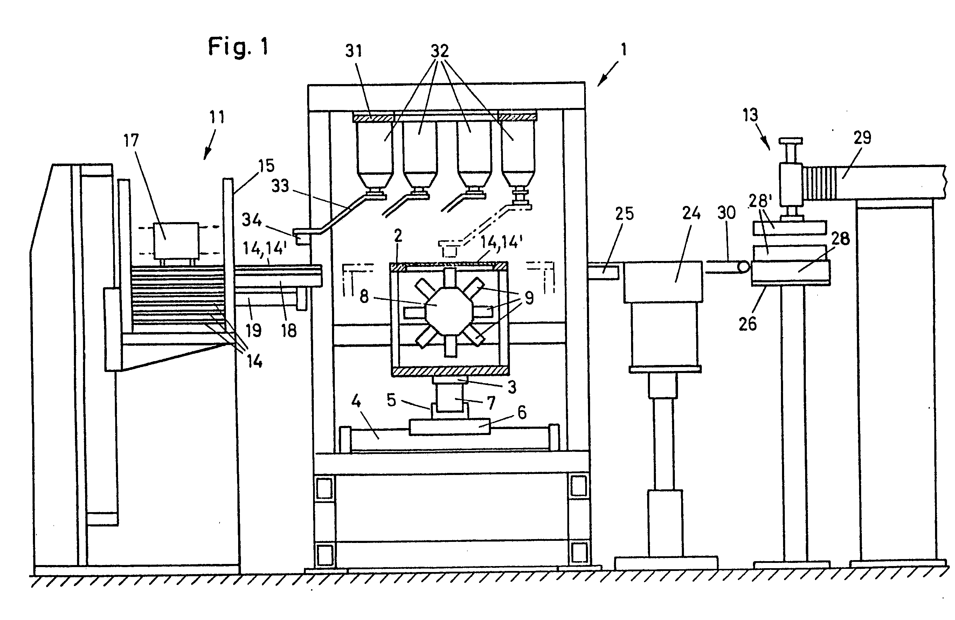

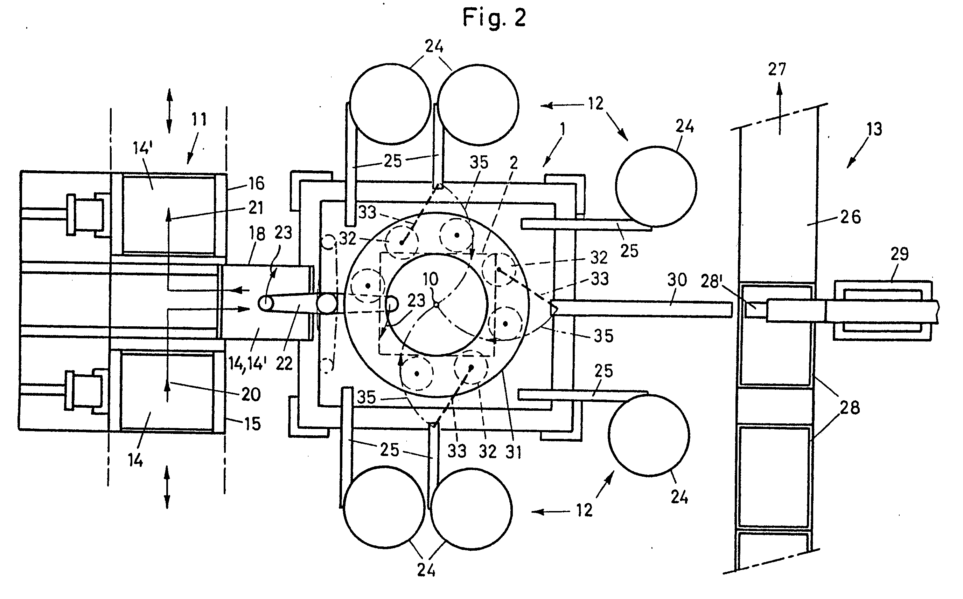

In den Fig. 1 und 2 ist eine rahmenförmig aufgebaute Montage- und Bestückungseinrichtung 1 dargestellt, welche einen Montagetisch 2 enthält. Der Montagetisch 2 ist über eine Hubeinrichtung 3 auf einer Schlittenanordnung gelagert, welche sich rechtwinklig kreuzende Schienen 4 und 5 enthält. Auf der ersten unteren Schiene 4, die am Rahmengestell der Montage- und Bestückungseinrichtung 1 befestigt ist, ist ein erster Schlitten 6 verschiebbar angeordnet. An diesem ersten Schlitten 6 ist die zweite, obere Schiene 5 befestigt, auf welcher ein zweiter Schlitten 7 verschiebbar angeordnet ist, der die Hubeinrichtung 3 trägt. Somit kann der Montagetisch 2 mittels nicht dargestellter Antriebe und einer ebenfalls nicht dargestellten elektrischen bzw. elektronischen Steuereinrichtung sowohl längs zweier zueinander senkrechter, waagrechter Koordinatenachsen als auch in der dazu senkrechten Höhenrichtung gesteuert verschoben werden. In Fig. 1 sind zwei Endpositionen des Montagetisches 2 in der einen Koordinatenrichtung strichpunktiert angedeutet. Unmittelbar unterhalb des Montagetisches 2 ist ein drehbarer Werkzeughalter 8 in fester Lage bezüglich des Rahmengestells angeordnet, der mit mehreren sternförmig verteilten Werkzeugen 9 versehen ist, welche in ihrer Arbeitsstellung im in Fig. 2 angedeuteten Zentrum 10 der Montage- und Bestückungseinrichtung 1 wirksam sind.

Auf den Aussenseiten der rahmenförmigen Montage- und Bestückungseinrichtung 1 ist diese mit verschiedenen Speicher- und Zuführeinrichtungen 11, 12 und 13 einerseits für Bauteile und anderseits für Bau- oder Schaltungselemente, mit welchen die Bauteile automatisch zu bestücken bzw. welche auf den Bauteilen zu montieren sind, versehen.

Die Speicher- und Zuführeinrichtung 11 für die Bauteile ist beim dargestellten Ausführungsbeispiel zur Aufnahme und Zuführung von zu bestückenden Leiterplatten 14 bzw. zur Aufnahme und Wegführung von bestückten Leiterplatten 14' ausgebildet. Die Leiterplatten 14, 14' sind in waagrechter Lage senkrecht übereinander in Behältern 15 und 16 gestapelt, wobei das Magazin 15 die zu bestückenden Leiterplatten 14 enthält und das Magazin 16 die bestückten Leiterplatten 14' aufnimmt. Beide Magazine 15, 16 sind in Richtung der Doppelpfeile verschiebbar, um volle Magazine 15 mit unbestückten Leiterplatten 14 zuzuführen bzw. die leeren Magazine 15 wegzuführen, und um leere Magazine 16 zuzuführen und volle Magazine 16 mit bestückten Leiterplatten 14' wegzuführen.

Wie aus den Fig. 1 und 2 in näher bezeichneter Weise ersichtlich ist, sind die Magazine 15, 16 als an sich bekannte Vertikalspeicher für die Leiterplatten 14, 14' ausgebildet, d.h. dass sie in der senkrechten Höhenrichtung derart verstellbar sind, dass in beiden Magazinen 15, 16 die jeweils oberste Leiterplatte 14 bzw. 14' sich immer auf einer festen gleichen Höhe befinden. Eine erste, nur in Fig. 1 schematisch dargestellte Verschiebevorrichtung 17, die oberhalb der Leiterplatte 14, 14' angeordnet ist, ist dazu ausgebildet, die jeweils oberste Leiterplatte 14 aus dem Magazin 15 auf einen Schiebetisch 18 zu schieben, der sich in gleicher Höhe wie die Leiterplatte 14 zwischen den beiden Magazinen 15 und 16 befindet. Ferner ist die Verschiebevorrichtung 17 dazu bestimmt, eine bestückte Leiterplatte 14', die sich auf dem genannten Schiebetisch 18 zwischen den beiden Magazinen 15, 16 befindet, in das Magazin 16 zu schieben. Zweckmässig erfolgen diese beiden Verschiebebewegungen gleichzeitig, d.h. mit der durch die Verschiebevorrichtung 17 aus dem Magazin 15 auf den Schiebetisch 18 geschobenen, unbestückten Leiterplatte 14 wird die bestückte Leiterplatte 14' vom Schiebetisch 18 in das Magazin 16 geschoben.

Der Schiebetisch 18 ist aus seiner in Fig. 2 nicht dargestellten Lage zwischen den beiden Magazinen 15 und 16 mittels einer zweiten, in Fig. 1 schematisch dargestellten Verschiebevorrichtung 19 in eine zweite Lage (Fig. 1, 2) nahe dem Montagetisch 2 sowie in der entgegengesetzten Richtung bewegbar. Entsprechend sind in Fig. 2 die Bewegungsrichtungen einer unbestückten Leiterplatte 14 durch einen Pfeil 20 und diejenigen einer bestückten Leiterplatte 14' durch einen Pfeil 21 angedeutet.

Um in der vorgenannten zweiten Lage des Schiebetisches 18 die darauf befindliche unbestückte Leiterplatte 14 auf den Montagetisch 2 bzw. eine auf den Montagetisch 2 befindliche bestückte Leiterplatte 14' auf den Schiebetisch 18 zu bringen, ist an der Bestückungs- und Montageeinrichtung 1 ein zweiarmiger, schwenkbarer Transferhebel 22 angeordnet, der an seinen beiden Enden mit Greifervorrichtung, z.B. Saugnäpfen, für die Leiterplatten 14, 14' versehen ist. Im Betrieb schwenkt der Transporthebel 22 aus der in Fig. 2 strichpunktiert dargestellten Ruhelage um 90°, erfasst mit seinem einen Hebelende eine auf dem Schiebetisch 18 liegende unbestückte Leiterplatte 14 und mit seinem anderen Hebelende eine auf dem Montagetisch 2 liegende bestückte Leiterplatte 14', schwenkt um 180° gemäss den Pfeilen 23, um die bestückte Leiterplatte 14' auf den Schiebetisch 18 und die unbestückte Leiterplatte 14 auf den Montagetisch 2 niederzulegen, und schwenkt schliesslich um 90° in die strichpunktiert dargestellte Ruhelage zurück. Hierbei sind Mittel (z.B. Zahnradgetriebe und ein Antriebsriemen) vorgesehen, welche bewirken, dass die Leiterplatten 14, 14' nicht eine Bewegung längs eines Kreises, sondern angenähert längs eines Parallelogramms oder eines Ovals ausführen, damit die Leiterplatten 14, 14' bei ihrer Schwenkbewegung nicht an den senkrechten Trägern des Rahmengestells der Beschickungs- und Montageeinrichtung 1 anstossen.

Bei der vorliegenden Ausführungsform sind die Speicher der Speicher- und Zuführeinrichtung 12 für die Bau- oder Schaltungselemente, mit welchen jeweils eine auf dem Montagetisch 2 befindliche Leiterplatte zu bestücken ist, als an sich bekannte Schwingförderer 24 ausgebildet, welche um den Montagetisch 2 auf den Aussenseiten des Rahmengestells der Bestückungs- und Montageeinrichtung 1 angeordnet sind. Jeder der hier insgesamt sechs Schwingförderer 24 ist mit einem Linearförderer 25 versehen, welcher die Bau- oder Schaltungselemente einzeln in eine bestimmte, nachstehend noch näher erläuterte Lage nahe dem Montagetisch 2 bringt.

Für andere Bau- oder Schaltungselemente, insbesondere solche grösserer Abmessungen, die durch einen Schwingförderer nicht vereinzelt und positioniert werden können, ist die weitere Speicher- und Zuführeinrichtung 13 vorgesehen. Diese umfasst ein Förderband oder eine Förderkette 26, welche taktweise in der Richtung des Pfeils 27 bewegt wird und auf welcher Paletten oder Behälter 28 mit in Kolonnen 28' angeordneten Bau- oder Schaltungselementen angeordnet sind. Eine Linear-Handhabungsvorrichtung 29 transportiert jeweils eine Kolonne 28' von Bau- oder Schaltungselementen auf ein Kleinförderband 30, um sie ebenfalls in eine bestimmte, nachstehend noch erläuterte Lage in Nähe des Montagetisches 2 zu bringen.

Eine weitere, in den Zeichnungen nicht dargestellte Ausführungsform der Speicher- und Zuführeinrichtung für die Bau- oder Schaltungselemente kann ein oder mehrere Stangenmagazine und ein daran anschliessendes Kleinförderband enthalten, durch welches die im Stangenmagazin gespeicherten Bau- oder Schaltungselemente einzeln ebenfalls in eine bestimmte Lage nahe dem Montagetisch 2 gebracht werden.

Um die Bau- oder Schaltungselemente nacheinander von den Linearförderern 25 bzw. dem Kleinförderband 30 auf die auf dem Montagetisch 2 befindliche Leiterplatte zu bringen, sind am Rahmengestell der Beschickungs- und Montageeinrichtung 1 mehrere Handhabungsvorrichtungen angeordnet. An einem am Rahmengestell in nicht näher dargestellter Weise befestigten Trägering 31 sind in Winkelabständen von 45° insgesamt sieben Betätigungsorgane 32 angeordnet, von welchen jedes einen schwenkbaren Greiferarm 33 (Fig. 1) hat. Am freien Ende jedes Greiferarms 33 ist ein Greifer 34 für ein Bau- oder Schaltungselement angebracht. Die Greiferarme 33 weisen zwischen ihrer Schwenkachse und ihrem Greifer 34 einen waagrechten Abstand auf, der gleich dem Radius des Kreises ist, auf dem die Betätigungsorgane 32 angeordnet sind bzw. ihre Schwenkachsen liegen. Dadurch wird erzielt, dass der Greifer 34 jedes Betätigungsorganes 32 bei einer Schwenkbewegung seines Greiferarms 33 über das Zentrum 10 (Fig. 2) der Bestückungs- und Montageeinrichtung 1 zu liegen kommt. Ferner befinden sich die freien Enden der Linearförderer 25 und des Kleinförderbands 30 in einer solchen Lage bezüglich der Bestückungs- und Montageeinrichtung 1, dass der Greifer 34 des Greiferarms 33 jedes Betätigungsorgans 32 im nach aussen geschwenkten Zustand über dem freien Ende eines zugeordneten Linearförderers 25 bzw. des Kleinförderbandes 30 liegt und somit das dort befindliche Bau- oder Schaltungselement ergreifen und durch eine nach innen gerichtete Schwenkbewegung des Greiferarms 33 zum genannten Zentrum 10 überführen kann. Diese Schwenkbewegung ist in Fig. 2 durch gebogene Pfeile 35 für drei der insgesamt sieben Betätigungsorgane 32 angedeutet.

Der automatisch ablaufende Bestückungs- und Montagevorgang ist damit der folgende, nachdem eine unbestückte Leiterplatte 14 in der zuvor beschriebenen Weise auf den Montagetisch 2 gelangt und dort mittels Anschlägen oder dgl. zentriert worden war.

Von einem der Speicher 24, 25 bzw. 28, 30 wird ein bestimmtes Bau- oder Schaltungselement durch den Greifer 34 des zugeordneten Betätigungsorganes 32 entnommen und zum Zentrum 10 befördert. Während dieses Vorganges wird der Montagetisch 2 mit der Leiterplatte 14 mittels der Schlittenanordnung 4, 5, 6, 7 sowie der Hubeinrichtung 3 derart verfahren, dass diejenige Stelle auf der Leiterplatte, an welcher das beförderte Bau- oder Schaltungselement auf der Leiterplatte einzusetzen ist, in das Zentrum 10 gelangt. Gleichzeitig wird ein bestimmtes Werkzeug 9 des Werkzeughalters 8 unter dem Montagetisch 2 in Stellung gebracht, so dass nach dem Einsetzen des Bau- oder Schaltungselementes in die Leiterplatte durch das Werkzeug 9 beispielsweise Anschlussdrähte des Bau- oder Schaltungselementes unter der Leiterplatte verschränkt werden können oder eine andere Bearbeitung vorgenommen werden kann.

In der Zeit, in welcher eine erste Handhabungsvorrichtung 32, 33, 34 die geschilderte Arbeit ausführt, kann mit einer zweiten Handhabungsvorrichtung 32, 33, 34 ein nächstes Bau- oder Schaltungselement seinem Speicher 24, 25 bzw. 28, 30 entnommen werden. Gleichzeitig mit dem Ausschwenken des Greifers 34 der ersten Handhabungsvorrichtung kann einerseits der Greifer 34 der zweiten Handhabungsvorrichtung mit dem weiteren Bau- oder Schaltungselement zum Zentrum 10 einwärts schwenken und anderseits der Montagetisch 2 in die erforderliche neue Position gefahren werden. Nach dem Einsetzen und Montieren aller vorgesehener Bau- oder Schaltungselemente wird die bestückte Leiterplatte 14' in das Magazin 16 gebracht, und es wird eine weitere, unbestückte Leiterplatte 14 vom Magazin 15 auf den Montagetisch 2 gefördert, wie dies bereits erläutert worden ist. Hierauf wiederholt sich der beschriebene Bestückungs- und Montagevorgang.

Alle diese Abläufe können mittels einer nicht näher erläuterten, programmierbaren Steuervorrichtung vollautomatisch erfolgen. Durch die koordinierten Abläufe kann die Transportzeit für die Bauteile und Bau- oder Schaltungselemente erheblich verkürzt werden.

Mit dem beschriebenen Bestückungs- und Montageautomaten lassen sich als Exoten bezeichnete Bau- und Schaltungselemente ungewöhnlicher Form und Abmessungen, wie beispielsweise Transformatoren, Stiftleisten, Druckleisten, Relais, Flachstecker, Kontaktstifte und dergleichen automatisch, rationell und serienmässig in Leiterplattten oder andere Bauteile montieren. Für reine Handmontage verbleiben nur noch beispielsweise Kühlbleche, überdimensionierte Kondensatoren, zusätzliche Abschirmungen und dergleichen übrig, was erfahrungsgemäss im Mittel höchstens 5% aller Bau- und Schaltungselemente ausmacht.

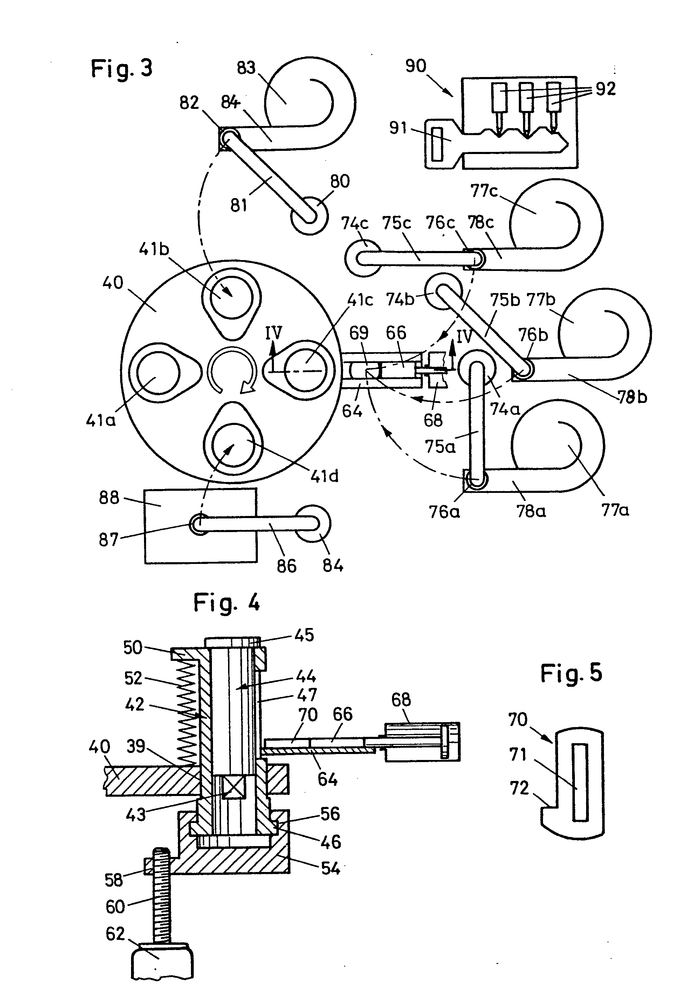

Die Ausführungsform nach Fig. 3 bis 5 ist zum Bestücken eines Schliesszylinders 44 mit Lamellen 70 vorgesehen. Im Schliesszylinder 44 sind axial gegeneinander versetzt mehrere dieser Lamellen 70 angeordnet. Die Lamellen 70 haben eine zentrale, rechteckige Öffnung 71, deren Länge von der gewünschten Schlüsselkontur an der betreffenden Stelle abhängt. Sie werden im Schliesszylinder durch eine auf eine Schulter 72 wirkende Feder vorbelastet und liegen deshalb mit einer Kante der Öffnung 71 am Schlüssel an.

Die leeren Schliesszylinder 44 werden durch einen Schwingförderer 83 und einen Linearförderer 84 einem Greifer 82 zugeführt und von diesem ergriffen. Der Greifer 82 ist an einem Greifarm 81 befestigt, der mittels eines Betätigungsorgans 80 den Greifer 82 aus der dargestellten Lage über eine Position 41b auf einem Drehtisch 40 schwenkt und dort absenkt. Der Schliesszylinder 44 wird dadurch in einen von vier Haltern 42 gesteckt, welche in Bohrungen 39 des Drehtisches 40 axial verschiebbar geführt sind. Der Halter 42 ist durch eine auf einen Ansatz 50 wirkende Feder 52 nach oben vorbelastet. Der Schliesszylinder 44 liegt mit einer Schulter 45 auf dem Halter 42 auf.

Nach Beendigung eines Zyklus schwenkt der Drehtisch 40 um 90°, wodurch der beladene Halter 42 in die Position 41c gelangt. Beim Einfahren in diese Position greift ein Endflansch 46 des Halters 42 in eine Nut 56 eines vertikal verschiebbaren Schlittens 54 ein. Die Stellung des Schlittens 54 wird durch einen Schrittmotor 62 über eine Gewindespindel 60 verändert, die in einen Ansatz 58 des Schlittens 54 eingeschraubt ist.

Drei Sorten Lamellen 70 werden durch je einen Schwingförderer 77a, b, c, über Linearförderer 78a, b, c je einem auf einem Greiferarm 75a, b, c montierten Greifer 76a, b, c zugeführt. Je nach der vorgegebenen Schlüsselkontur und der momentanen axialen Stellung des Halters 42 wird eine Lamelle von einem der Greifer 76 ergriffen und durch einen zugehörigen Schwenkmotor 74a, b, c in eine Rinne 69 einer Gleitplatte 64 gebracht. Von dort wird die Lamelle 70 mittels eines Zylinders 68 und eines Schiebers 66 in den Schliesszylinder 44 eingeschoben. Dazu weist der Halter 42 einen gegen den Schieber 66 gerichteten Schlitz 47 auf.

Zur Bestimmung der gewünschten Schlüsselkontur ist ein Schlüssellesegerät 90 vorgesehen, in welchem die Kontur eines eingesteckten Schlüssels 91 mittels Tastern 92 abgetastet wird. Statt mit der dargestellten Mehrzahl von Tastern 92 kann die Kontur auch mit einem einzelnen, längsverschiebbaren Taster abgelesen und die Messwerte gespeichert werden.

Zur Bestückung des Schliesszylinders 44 wird zunächst in der in Fig. 4 dargestellten obersten Stellung des Halters 42 eine der drei verschiedenen Lamellen 70 entsprechend der im Lesegerät 90 ermittelten und gespeicherten Schlüsselkontur durch den entsprechenden Greifer 76 ergriffen, in die Rinne 69 eingelegt und durch den Schieber 66 in den Schliesszylinder 44 eingeschoben. Hierauf wird der Schlitten 54 durch den Schrittmotor 62 um eine Stufe abgesenkt und die nächste Lamelle entsprechend der Schlüsselkontur an dieser Stelle eingeführt. Dieser Vorgang wiederholt sich, bis in sämtliche Positionen die zugehörigen Lamellen 70 eingesetzt sind.

Anschliessend wird der Schliesszylinder 44 um 90° gedreht, z.B. durch einen nicht dargestellten, in die Schlüsselöffnung eingreifenden Drehzylinder, der Schlitten 54 wieder in seine obere Endlage gefahren und der Drehtisch 40 um 90° gedreht. In der Entladeposition 41d wird nun der bestückte Schliesszylinder 44 zunächst gesichert, z.B. durch Verklemmen mittels einer nicht dargestellten Klemmvorrichtung, durch einen auf einem Greiferarm 86 befestigten Greifer 87 ergriffen, durch ein Betätigungsorgan 84 aus dem Halter 42 gehoben und über einen Verpackungsbehälter 88 geschwenkt, wo er zusammen mit dem zugehörigen Schlüssel 91 verpackt und abtransportiert wird.

Es ist natürlich möglich, mehr als drei Sorten Lamellen 70 und entsprechend mehr Schwingförderer 77, Schwenkmotore 74, Greiferarme 75 und Greifer 76 vorzusehen. Es ist auch möglich, die Lamellen 70 von zwei diametral gegenüberliegenden Seiten in den Schliesszylinder 44 einzuführen. Dazu kann der erwähnte, nicht dargestellte Drehzylinder eingesetzt werden. Dies entspricht einer zweiten Verschiebungsrichtung des Halters 42.

Die Sicherung des Schliesszylinders 44, z.B. durch Verklemmen, kann auch in einer separaten, zwischen der Bestückungsposition 41c und der Entladeposition 41d angeordneten Position erfolgen.

## Patentansprüche

1. Bestückungs- und Montageautomat zur Bestückung von Bauteilen für Maschinen, Geräte oder elektrische Anordnungen mit einzelnen unterschiedlichen Bau- oder Schaltungselementen, umfassend einen in einer Richtung verschiebbaren Halter (2; 42) zur Aufnahme jeweils eines Bauteils (14; 44), mehrere Speicher (24, 28; 77) für je eine Sorte der Bau- oder Schaltungselemente, sowie eine Handhabungsvorrichtung (32–34; 74–76) zur Entnahme jeweils eines Bau- oder Schaltungselementes aus seinem Speicher (24, 28; 77) und zur Anordnung des entnommenen Bau- oder Schaltungselementes auf dem sich auf dem Halter befindlichen Bauteil, dadurch gekennzeichnet, dass der Halter (2; 42) auf einer Schlittenanordnung (4–7; 39, 42) in mindestens der erwähnten Richtung programmiert verschiebbar ist, dass jedem Speicher (24, 28; 77) je eine Handhabungsvorrichtung (32–34; 74–76) zugeordnet ist, und dass das entsprechende Bau- oder Schaltungselement durch jede Handhabungsvorrichtung (32–34; 74–76) je einer allen Handhabungsvorrichtungen (32–34; 74–76) gemeinsamen ortsfesten Stelle (10; 69) zuführbar ist.

2. Automat nach Anspruch 1, dadurch gekennzeichnet, dass der Halter (2; 42) auf der Schlittenanordnung (4–7; 39, 42) in mindestens zwei Richtungen verschiebbar ist.

3. Automat nach einem der vorangehenden Ansprüche, gekennzeichnet durch eine Speicher- und Transporteinrichtung (15–19, 22; 80–84) zum Zuführen jeweils eines Bauteils (14; 44) auf den Halter (2; 42).

4. Automat nach Anspruch 3, dadurch gekennzeichnet, dass die Speichereinrichtung zwei Magazine (15, 16) enthält, die auf zwei getrennten Transportbahnen in entgegengesetzten Richtungen verschiebbar sind, die ferner zur Aufnahme eines Stapels von Bauteilen (14) ausgebildet sind, und von denen das eine (15) zur Aufnahme und Zuführung unbestückter Bauteile (14) und das andere (16) zur Aufnahme und Wegführung bestückter Bauteile (14') ausgebildet ist.

5. Automat nach Anspruch 4, dadurch gekennzeichnet, dass jedem Magazin (15, 16) eine Transporteinrichtung (17, 18, 19, 22) zugeordnet ist, welche dazu ausgebildet ist, je ein unbestücktes Bauteil (14) des einen Magazins (15) zum Montagetisch (2) und ein bestücktes Bauteil (14') vom Montagetisch (2) zum anderen Magazin (16) zu bewegen.

6. Automat nach einem der vorangehenden Ansprüche, dadurch gekennzeichnet, dass die Speicher (24–18; 77) für die Bau- oder Schaltungselemente im Aussenbereich eines den Halter (2; 42) lagernden Gestells angeordnet sind.

7. Automat nach einem der vorangehenden Ansprüche, dadurch gekennzeichnet, dass die Speicher für die Bau- oder Schaltungselemente mindestens einen Schwingförderer (24; 77) enthalten.

8. Automat nach einem der vorangehenden Ansprüche, dadurch gekennzeichnet, dass die Speicher für die Bau- oder Schaltungselemente mehrere auf einem Förderband oder einer Förderkette (26) angeordnete Paletten oder Behälter (28) enthalten.

9. Automat nach einem der vorangehenden Ansprüche, dadurch gekennzeichnet, dass die Speicher für die Bau- oder Schaltungselemente mindestens ein Stangenmagazin enthalten.

10. Automat nach einem der vorangehenden Ansprüche, dadurch gekennzeichnet, dass jedem Speicher, für die Bau- oder Schaltungselemente (24, 28; 77) eine Fördereinrichtung, z.B. ein Linearförderer (25; 78) oder ein Kleinförderband (30) zugeordnet ist, welche sich in die Nähe des Halters (2; 42) erstreckt.

11. Automat nach einem der vorangehenden Ansprüche, dadurch gekennzeichnet, dass jede Handhabungsvorrichtung einen mit einem Greifer (34, 76) versehenen Greiferarm (33, 75) sowie ein den Greiferarm (33; 75) schwenkendes und auf den Greifer (34; 76) einwirkendes Betätigungsorgan (32; 74) hat.

12. Automat nach einem der vorangehenden Ansprüche, dadurch gekennzeichnet, dass bezüglich des in den Halter (2) eingesetzten Bauteils (14) gegenüberliegend der ortsfesten Stelle (10) ein Werkzeug (9) zur Bearbeitung des in das Bauteil (14) eingesetzten Bau- oder Schaltungselementes vorgesehen ist.

13. Automat nach Anspruch 12, dadurch gekennzeichnet, dass mehrere Werkzeuge (9) in einem drehbaren Werkzeughalter (8) angeordnet sind, und dass das sich jeweils in Arbeitsstellung befindliche Werkzeug (9) gegenüberliegend der für alle Handhabungsvorrichtungen (32, 33, 34) gemeinsamen, ortsfesten Stelle (10) liegt.

14. Automat nach einem der vorangehenden Ansprüche, dadurch gekennzeichnet, dass der Halter (42) auf einem Drehtisch (40) längs einer Achse verschiebbar gelagert ist, und dass in der Montageposition (41c) des Drehtisches (40) eine Verschiebeeinrichtung (54, 60, 62) mit dem Halter (42) im Eingriff ist.

**Claims**

1. Automatic fitting and mounting machine for fitting construction units for machines, appliances or electrical arrangements with individual different components or circuit elements, comprising a holder (2; 42), which can be displaced in one direction and is intended for accommodating in each case a construction unit (14; 44), several storage means (24, 28; 77) for one type of component or circuit element each, and also a manipulating device (32–34; 74–76) for removing in each case a component or circuit element from a storage means (24, 28; 77) and for arranging the removed component or circuit element on the construction unit located on the holder, characterized in that the holder (2; 42) can be displaced in a programmed manner on a slide arrangement (4–7; 39, 42) in at least the abovementioned direction, that a manipulating device (32–34; 74–76) is in each case allocated to each storage means (24, 28; 77), and that a corresponding component or circuit element can be fed by each manipulating device (32, 34; 74–76) in each case to a fixed location (10; 69) common to all manipulating devices (32–34; 74–76).

2. Automatic machine according to Claim 1, characterized in that the holder (2; 42) can be displaced on the slide arrangement (4-7; 39, 42) in at least two directions.

3. Automatic machine according to one of the preceding claims, characterized by a storage and transfer apparatus (15-19, 22; 80-84) for feeding in each case a construction unit (14; 44) to the holder (2; 42).

4. Automatic machine according to Claim 3, characterized in that the storage apparatus contains two magazines (15, 16) which can be displaced on two separate transfer paths in opposite directions, which, moreover, are designed for accommodating a stack of construction units (14) and of which one (15) is designed for accommodating and feeding unfitted construction units (14) and the other (16) is designed for accommodating and taking away fitted construction units (14').

5. Automatic machine according to Claim 4, characterized in that allocated to each magazine (15, 16) is a transfer apparatus (17, 18, 19, 22) which is designed for moving in each case an unfitted cosntruction unit (14) of one magazine (15) to the mounting table (2) and a fitted construction unit (14') from the mounting table (2) to the other magazine (16).

6. Automatic machine according to one of the preceding claims, characterized in that the storage means (24-28; 77) for the components or circuit elements are arranged in the outer area of a stand mounting holder (2; 42).

7. Automatic machine according to one of the preceding claims, characterized in that the storage means for the components or circuit elements contain at least one vibrating conveyor (24; 77).

8. Automatic machine according to one of the preceding claims, characterized in that the storage means for the components or circuit elements contain several pallets or containers (28) arranged on a conveyor belt or a conveyor chain (26).

9. Automatic machine according to one of the preceding claims, characterized in that the storage means for the components or circuit elements contain at least one rod magazine.

10. Automatic machine according to one of the preceding claims, characterized in that allocated to each storage means (24, 28; 77) for the components or circuit elements is a conveying apparatus, eg. a linear conveyor (25; 78) or a small conveyor belt (30), which extends into the proximity of the holder (2; 42).

11. Automatic machine according to one of the preceding claims, characterized in that each manipulating device has a gripper arm (33; 75), provided with a gripper (34; 76), and also an actuating member (32; 74) swivelling the gripper arm (33; 75) and acting on the gripper (34; 76).

12. Automatic machine according to one of the preceding claims, characterized in that, with respect to the construction unit (14) inserted into the holder (2), opposite the fixed location (10), a tool (9) is provided for working the component or circuit element inserted into the construction unit (14).

13. Automatic machine according to Claim 12, characterized in that several tools (9) are arranged in a rotatable tool holder (8), and that the tool (9) located in each case in the working position lies opposite the fixed location (10) common to all manipulating devices (32, 33, 34).

14. Automatic machine according to one of the preceding claims, characterized in that the holder (42) is displaceably mounted on a turntable (40) along an axis, and that, in the mounting position (41c) of the turntable (40), a displacing apparatus (54, 60, 62) is engaged with the holder (42).

**Revendications**

1. Automate d'équipement et de montage pour l'équipement de pièces détachées, pour machines, appareils ou dispositifs électriques, en composants ou éléments de circuits individuels différents, comprenant un support porteur (2; 42) susceptible de coulisser dans une direction pour prélever chaque fois une pièce détachée (14; 44), plusieurs réservoirs (24, 28; 77) chacun pour un type particulier de composants ou d'éléments de circuit, ainsi qu'un dispositif de manipulation (32-34; 74-76) pour prélever chaque fois un composant ou un élément de circuit de son réservoir (24, 28; 77) et pour disposer le composant ou l'élément de circuit, prélevé, sur la pièce détachée qui se trouve sur le support porteur, caractérisé en ce que le support porteur (2; 42) peut coulisser de façon programmée sur un dispositif à glissières (4-7; 39, 42) dans au moins la direction mentionnée, en ce qu'un dispositif de manipulation (32-34; 74-76) est associé à chaque réservoir (24, 28; 77) et en ce que le composant ou l'élément de circuit correspondant peut être acheminé par chaque dispositif de manipulation (32-34; 74-76), chacun dans un endroit particulier fixe (10; 69) commun à tous les dispositifs de manipulation (32-34; 74-76).

2. Automate selon la revendication 1, caractérisé en ce que le support porteur (2; 42) peut coulisser sur le dispositif à glissières (4-7; 39, 42) dans au moins deux directions.

3. Automate selon l'une des revendications précédentes, caractérisé par un dispositif de réserve et de transport (15-19, 22; 80-84) pour acheminer chaque fois une pièce détachée (14; 44) sur le support porteur (2; 42).

4. Automate selon la revendication 3, caractérisé en ce que le dispositif de réserve comprend deux magasins (15, 16) qui peuvent coulisser dans des sens opposés sur deux voies de transport séparées et qui sont en outre réalisés pour prélever une pile de pièces détachées (14), l'un (15) de ceux-ci étant conçu pour prélever et délivrer des pièces détachées non équipées (14) et dont l'autre (16) est conçu pour prélever et évacuer des pièces détachées équipées (14').

5. Automate selon la revendication 4, caractérisé en ce qu'à chaque magasin (15, 16) est associé un dispositif de transport (17, 18, 19, 22) qui est conçu pour déplacer chacun une pièce détachée non équipée (14) d'un des magasins (15) jusqu'à la table de montage (2) et une pièce détachée equipée (14') de la table de montage (2) jusqu'à l'autre magasin (16).

6. Automate selon l'une des revendications précédentes, caractérisé en ce que les réservoirs (24–28; 77) de composants ou d'éléments de circuit sont disposés dans la région extérieure d'un bâti qui reçoit le support porteur (2; 42).

7. Automate selon l'une des revendications précédentes, caractérisé en ce que les réservoirs de composants ou d'éléments de circuit comprennent au moins un convoyeur oscillant (24; 77).

8. Automate selon l'une des revendications précédentes, caractérisé en ce que les réservoirs de composants ou d'éléments de circuit comprennent plusieurs palettes ou conteneurs (28) disposés sur une bande transporteuse ou une chaîne transporteuse (26).

9. Automate selon l'une des revendications précédentes, caractérisé en ce que les réservoirs de composants ou d'éléments de circuit comprennent au moins un magasin à barres.

10. Automate selon l'une des revendications précédentes, caractérisé en ce qu'à chaque réservoir (24, 28; 77) de composants ou d'éléments de circuit est associé un dispositif de transport, par exemple un transporteur linéaire (25; 78) ou une petite bande transporteuse (30), qui s'étend au voisinage du support porteur (2; 42).

11. Automate selon l'une des revendications précédentes, caractérisé en ce que chaque dispositif de manipulation comprend un bras de préhension (33; 75) muni d'un grappin (34; 76) ainsi qu'un organe de manœuvre (32; 74) qui fait pivoter le bras de préhension (33; 75) et agit sur le grappin (34; 76).

12. Automate selon l'une des revendications précédentes, caractérisé en ce qu'un outil (9), pour effectuer un travail sur le composant ou l'élément de circuit inséré dans la pièce détachée (14), est prévu en face de l'endroit fixe (10) par rapport à la pièce détachée (14) placée dans le support (2).

13. Automate selon la revendication 12, caractérisé en ce que plusieurs outils (9) sont disposés dans un support porteur d'outils (8) tournant et en ce que l'outil (9) qui se trouve effectivement dans la position de travail est disposé en face de l'endroit fixe (10) commun à tous les dispositifs de manipulation.

14. Automate selon l'une des revendications précédentes, caractérisé en ce que le support porteur (42) est monté de façon coulissante le long d'un axe sur une table tournante (40) et en ce que, dans la position de montage (41c) de la table tournante (40), un dispositif de coulissement (54, 60, 62) est en prise avec le support porteur (42).

Fig. 1

0 140 837

# Fig. 2

Fig. 3

Fig. 4

Fig. 5